# EUROPEAN PATENT APPLICATION

(11) **EP 4 810 673 A1**
(43) Date of publication of application: **23.09.2026**
(21) Application number: 24891216.4
(22) Date of filing: 30.10.2024
(51) Int. Cl.: C30B 15/08, B01J 19/12, B21C 37/04, B22D 11/00

(54) **TREATMENT DEVICE AND METHOD**

(30) Priority: 17.11.2023 JP 2023195964
(71) Applicant: C & A Corporation, Sendai-shi, Miyagi 980-0811 (JP); Tohoku University, Sendai-shi, Miyagi 980-8577 (JP)
(72) Inventor: MURAKAMI, Rikito, Sendai-shi, Miyagi 980-8577 (JP); YOSHIKAWA, Akira, Sendai-shi, Miyagi 980-8577 (JP); KAMADA, Kei, Sendai-shi, Miyagi 980-8577 (JP); ITOI, Shiika, Sendai-shi, Miyagi 980-0811 (JP)
(74) Representative: Samson & Partner Patentanwälte mbB
(86) International application number: PCT/JP2024/038628
(87) International publication number: WO 2025/105175

(57) **Abstract**

A high-frequency irradiation means (101) irradiates liquid (122) contained in a container (121) with high-frequency electromagnetic waves. A supply means (102) supplies raw material to the liquid (122). A frequency measurement means (103) measures a frequency of the high-frequency electromagnetic waves irradiated by the high-frequency irradiation means (101). A control means (104) controls the supply of raw material by the supply means (102) in accordance with the rate of change of a reference value, the reference value being based on maximum and minimum amplitude values for each cycle period for the frequency measured by the frequency measurement means (103).

## Description

### TECHNICAL FIELD

The present invention relates to a processing apparatus and a method.

### BACKGROUND ART

For example, various crystal growth apparatuses are being used and examined. In Patent Document 1, circuit elements are controlled so that the heating oscillation frequency is kept constant, and the diameter of the growing crystal is controlled by adjusting the moving speed of the crystal.

### Prior art document

Patent Document 1: Japanese Patent Publication No. S60-024077

### SUMMARY OF THE INVENTION

However, the above-mentioned conventional technique has the problem that it does not allow crystal growth with uniform and high-quality crystallinity. This is because the melt into which the raw material is supplied does not maintain uniformity, for example in its composition.

The present invention has been made to solve the above problems and aims to obtain uniformity in the liquid into which the raw material is supplied.

A processing apparatus according to the present invention comprises:
a high-frequency irradiation means for irradiating a liquid contained in a container with high-frequency electromagnetic waves;
a supply means for supplying a raw material to the liquid;
a frequency measurement means for measuring a frequency of the high-frequency electromagnetic waves irradiated by the high-frequency irradiation means; and
a control means for controlling the supply of the raw material by the supply means according to a rate of change of a reference value, the reference value being based on a maximum amplitude value and a minimum amplitude value per cycle period for the frequency measured by the frequency measurement means.

In one exemplary configuration of the above-described processing apparatus, the supply means supplies the raw material by any of dripping the raw material, ejecting the raw material, and spraying the raw material, and the control means controls any of an amount of raw material dripped, an amount of raw material ejected, and an amount of raw material sprayed.

In one exemplary configuration of the above-described processing apparatus, the supply means supplies the raw material by any of dripping the raw material, ejecting the raw material, and intermittently supplying the raw material, and the control means controls an interval between any of dripping operations, successive ejecting operations, and successive intermittent supply operations of the raw material.

In one exemplary configuration of the processing apparatus, the control means controls any of an amount of raw material dripped, an amount of raw material ejected, and an amount of raw material sprayed.

In one exemplary configuration of the processing apparatus, the control means controls an interval between any of dripping operations, successive ejecting operations, and successive intermittent supply operations of the raw material.

In one exemplary configuration of the processing apparatus, the high-frequency irradiation means heats the liquid by high-frequency induction heating.

In one exemplary configuration of the processing apparatus, the processing apparatus further comprises a stopping means for stopping an operation of the processing apparatus in response to a fluctuation range of a rate of change of the reference value.

In addition, a processing method according to the present invention comprises the steps of:
a high-frequency irradiation step of irradiating a liquid contained in a container with high-frequency electromagnetic waves;
a supply step of supplying a raw material to the liquid;
a frequency measurement step of measuring a frequency of the high-frequency electromagnetic waves irradiated in the high-frequency irradiation step; and
a control step of controlling the supply of the raw material in the supply step according to a rate of change of a reference value, the reference value being based on a maximum amplitude value and a minimum amplitude value per cycle period for the frequency measured in the frequency measurement step.

In one exemplary configuration of the above-described processing method, the supply step supplies the raw material by any of dripping the raw material, ejecting the raw material, and spraying the raw material, and the control step controls any of an amount of raw material dripped, an amount of raw material ejected, or an amount of raw material sprayed.

In one exemplary configuration of the above-described processing method, the supply step supplies the raw material by any of dripping the raw material, ejecting the raw material, and intermittent supply of the raw material, and the control step controls an interval between any of dripping operations, successive ejecting operations, and successive intermittent supply operations of the raw material.

In one exemplary configuration of the above-described processing method, the high-frequency irradiation step involves heating the liquid by high-frequency induction heating.

In one exemplary configuration of the processing method, the method further comprises a stopping step of stopping an operation of the apparatus in response to a fluctuation range of a rate of change of the reference value.

As described above, according to the present invention, the supply of raw material is controlled according to the frequency of the high-frequency electromagnetic waves produced onto the liquid contained in the container, and therefore it is possible to achieve uniformity in the liquid into which the raw material is supplied.

### BRIEF DESCRIPTION OF THE DRAWINGS

FIG. 1 shows a block diagram illustrating a configuration of a processing apparatus according to an embodiment of the present invention.
FIG. 2 shows a block diagram illustrating a more detailed configuration of the processing apparatus according to the embodiment of the present invention.
FIG. 3 shows a characteristic diagram illustrating the relationship between the oscillator frequency and time when a reference value, the reference value being based on the maximum and minimum amplitude values per cycle period for the frequency, is changed while the raw material is supplied during crystal growth.
FIG. 4 shows a flowchart illustrating an example of a flow of the work amount to be adjusted according to the rate of change of a reference value, the reference value being based on the maximum and minimum amplitude values per cycle period for the frequency, shown in FIG. 3.
FIG. 5 shows a characteristic diagram illustrating the relationship between the oscillator frequency and time when a reference value, the reference value being based on the maximum and minimum amplitude values per cycle period for the frequency, is changed during the supply of raw material during crystal growth.
FIG. 6 shows a characteristic diagram illustrating the relationship between the concentration of the solute metal element and the crystallization rate in the produced alloy wire.
FIG. 7 shows a block diagram illustrating a partial hardware configuration of a processing apparatus according to an embodiment of the present invention.

### DETAILED DESCRIPTION OF THE INVENTION

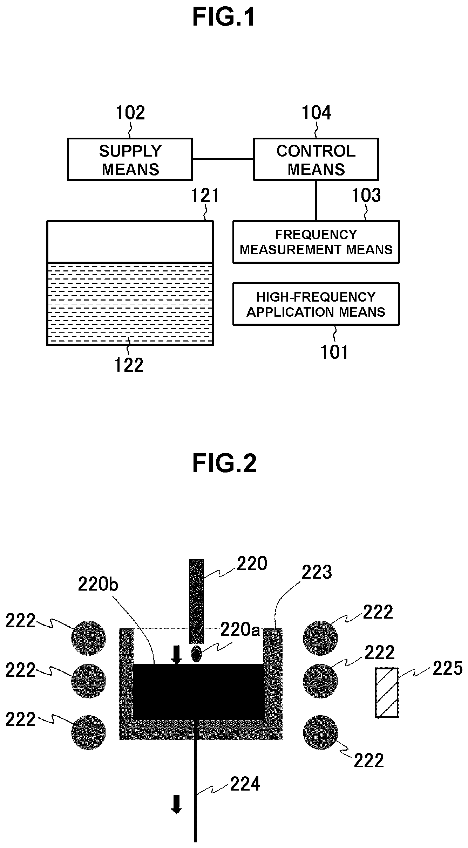

A processing apparatus according to an embodiment of the present invention will be described now with reference to FIG. 1. The processing apparatus includes a high-frequency irradiation means 101, a supply means 102, a frequency measurement means 103, and a control means 104.

The high-frequency irradiation means 101 irradiates liquid 122 contained in a container 121 with high-frequency electromagnetic waves. For example, the high-frequency irradiation means 101 can be configured to heat the liquid 122 by high-frequency induction heating. In this case, the processing apparatus can be a crystal growth apparatus in which the container 121 is a crucible and the liquid 122 is a melt.

The supply means 102 supplies the raw material to the liquid 122. For example, the supply means 102 can supply the raw material by dripping the raw material, by ejecting the raw material, by spraying the raw material, or by intermittently supplying the raw material. The supply means 102 can be a well-known raw material supply device used for crystal growth.

The frequency measurement means 103 measures the frequency of the high-frequency electromagnetic waves produced by the high-frequency irradiation means 101. The frequency measurement means 103 can be configured by a measurement device such as a well-known frequency counter.

The control means 104 controls the supply of raw material by the supply means 102 in accordance with the rate of change of a reference value, the reference value being based on the maximum and minimum amplitude values per cycle period for the frequency measured by the frequency measurement means 103. For example, the control means 104 can control any of an amount of raw material dripped, an amount of raw material ejected, and an amount of raw material sprayed. The control means 104 can also control an interval between any of dripping operations, intervals between successive ejecting operations, and intervals between successive intermittent supply operations of the raw material.

The reference value is not particularly limited as long as it is a value based on the maximum and minimum amplitude values per cycle period for the frequency. Suitable examples of the reference value include an arithmetic mean value or a geometric mean value of the maximum and minimum amplitude values. Here, when the supply means 102 drips, ejects, sprays, or intermittently supplies the raw material, the waveform of the measured frequency exhibits spike-like protrusions at the maximum and minimum amplitude values. In this way, the spike-like portion makes it easy to determine the maximum and minimum amplitude values. The control means 104 can perform control by means of the spike-like signals described above. For example, the control means 104 can control the supply of raw material by the supply means 102 using conventionally known control (such as PID control), etc.

The processing apparatus may further include a stopping means (not illustrated) for stopping the operations of the respective means (the processing apparatus itself) of the processing apparatus in accordance with the fluctuation range of the rate of change of the reference value. For example, various determinations can be made based on whether the rate of change of a reference value, the reference value being based on the maximum and minimum amplitude values per cycle period for the measured frequency, is within a certain range or not, including whether there is a change or not. For example, a normal rate of change of the reference value can be obtained in advance such that the range of the obtained normal rate of change of the reference value is used as the above-described certain range. The wording "for a cycle period" indicates "for a fixed time" (for example, "for one second" to "for an hour") of a frequency corresponding to a repeating unit of a waveform of the frequency having maximum and minimum amplitude values. In the present invention, the rate of change of the reference value is preferably based on the fluctuation of the reference value or its rate of fluctuation. Within such a preferred range, the raw material can be supplied industrially more advantageously.

The raw material is not particularly limited in terms of its shape, etc., as long as it does not impede the object of the present invention. The shape of the raw material may be, for example, droplets, powder, or granules, but there is no particular limitation on the particle size, etc. The raw material is not particularly limited, and may be, for example, an inorganic material or an organic material. For example, for crystal growth, it is preferable to form the raw material into a crystal-rod shape, and the supply means can be configured to supply droplets obtained by melting the crystal rod. This preferred embodiment is advantageous because it can more easily cope with spike-like frequencies that may occur due to the supply of raw materials.

Meanwhile, "high-frequency induction heating" is a heating technique that uses high-frequency electromagnetic waves to cause a current to flow through an object to generate heat based on the principle of electromagnetic induction, and can use frequencies of, for example, about 3 kHz to 300 MHz. The high-frequency irradiation means for carrying out high-frequency induction heating is not particularly limited as long as it does not impede the object of the present invention, and may include a heating coil, etc. In this case, the state of the resulting crystal can be more easily controlled by further performing control to move the position of the heating coil.

The processing apparatus can be applied to, for example, a crystal growth apparatus. The crystal growth apparatus can be, for example, a µ-PD apparatus. Moreover, the processing apparatus of the present invention can be suitably applied not only to crystal growth apparatuses but also to stable supply, preferably stable continuous supply, of a raw material by dripping, ejecting, spraying or intermittently supplying them. Examples of application of the processing apparatus other than crystal growth apparatuses include a mixing apparatus, a film-forming apparatus, a chemical reaction apparatus, a cooking apparatus, a coating apparatus, a physical reaction apparatus, and an analysis apparatus.

The processing method according to the embodiment includes the steps of, a high-frequency irradiation step of irradiating a liquid 122 contained in the container 121 with high-frequency electromagnetic waves by a high-frequency irradiation means; a supply step of supplying raw material to liquid 122 by a supply means 102; a frequency measurement step of measuring a frequency of the high-frequency electromagnetic waves produced in the high-frequency irradiation step by a frequency measurement means 103; and a control step of controlling, by a control means 104, the supply of raw material in the supply step in accordance with the rate of change of a reference value, the reference value being based on the maximum amplitude and minimum amplitude values per cycle period for the frequency measured in the frequency measurement step.

In the supply step, it is possible to supply the raw material by any of dripping the raw material, ejecting the raw material, spraying the raw material, and intermittent ejection of the raw material. In the control step, it is possible to control any of an amount of raw material dripped, an amount of raw material ejected, and an amount of raw material sprayed. In the control step, it is possible to control in interval between any of dripping operations, intervals between successive ejecting operations, and intervals between successive intermittent supply operations of the raw material.

The high-frequency irradiation step may be configured to heat the liquid by high-frequency induction heating. The method may further include a stopping step of stopping the operation of the processing apparatus (the processing apparatus itself) according to the fluctuation range of the rate of change of the reference value.

The present invention will be explained in more detail now using examples. The following describes a case where the processing apparatus is applied to a crystal growth apparatus (µ-PD apparatus) shown in FIG. 2. This apparatus includes, a high-frequency induction heating coil 222 which serves as a high-frequency irradiation means; a reaction container 223; and a frequency measurement device 225. Using this apparatus, a crystal rod (supply rod) 220 is heated by a high-frequency induction heating coil 222 to produce droplets 220a, which are then supplied to a melt 220b contained in the reaction container 223.

In this apparatus, the melt 220b is reduced as the wire 224 grows, and therefore the frequency irradiated from the high-frequency induction heating coil 222 to the melt 220b changes. This change is measured by a frequency measurement device 225, and a controller (control means), not illustrated, obtains the rate of change of a reference value, the reference value being based on the maximum and minimum amplitude values per cycle period for the measured frequency, and controls the supply speed of the crystal rod 220 such that the obtained rate of change falls within a certain range. By controlling the supply speed of the crystal rod 220, the state of the droplets 220a can be controlled.

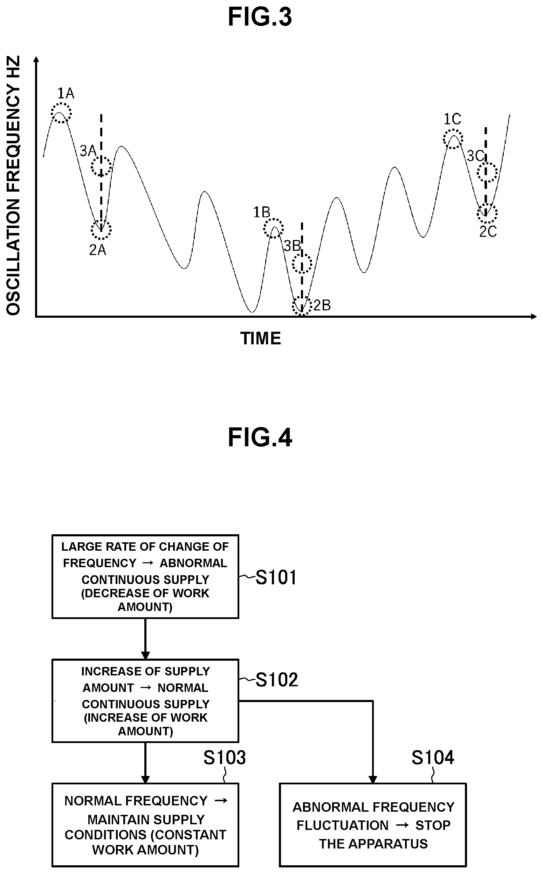

FIG. 3 shows the relationship between the oscillator frequency and time when a reference value, the reference value being based on the maximum and minimum amplitude values per cycle period for the frequency, is changed during the supply of raw material during crystal growth. Although examples in which a geometric mean value is used as the reference value are given, the present invention is not limited to such specific examples.

In FIG. 3, when the rate of change of the geometric mean value 3A based on the maximum amplitude 1A and the minimum amplitude 2A increases as the crystal growth (growth of the wire 224) progresses, the supply speed of the crystal rod 220 is adjusted such that the supply amount is increased at the time corresponding to the geometric mean value 3B based on the maximum amplitude 1B and the minimum amplitude 2B to return to a normal supply state such that the rate of change of a reference value, the reference value being based on the maximum amplitude and the minimum amplitude per cycle period for the frequency, is returned to a normal state. However, if the rate of change of the reference value at the time corresponding to the geometric mean value 3C based on the maximum amplitude value 1C and the minimum amplitude value 2C continues to be abnormal even if the supply amount is increased at the time of the geometric mean value 3B, the apparatus can be stopped using a stop feature (not illustrated). By adopting such a configuration, the raw material can be supplied to the melt more easily and more stably.

FIG. 4 shows a flowchart illustrating an example of a flow of the work amount to be adjusted in accordance with the rate of change of the reference value, the reference value being based on the maximum and minimum amplitude values per cycle period for the frequency, in FIG. 3. For example, when the rate of change of the geometric mean value 3A based on the maximum amplitude value 1A and the minimum amplitude value 2A becomes large, it is determined to be an abnormal continuous supply (decrease in the work amount) (step S101), and then the supply amount is increased, for example, at the time of the geometric mean value 3B, to return to a normal continuous supply state (step S102) such that the rate of change of the reference value is returned to a normal state (step S103). If, for example, an abnormality is still observed in the rate of change of the geometric mean value 3C even if the supply amount is increased at the time corresponding to the geometric mean value 3B, the apparatus is stopped (step S104).

Evaluation of the crystal (wire) thus actually produced will be described now.

### Preparation of alloy wire

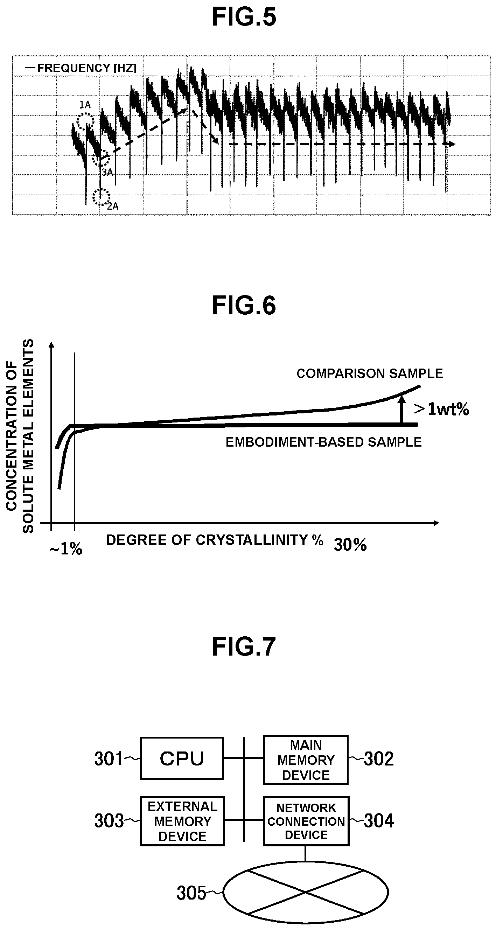

Using the apparatus described with reference to FIG. 2, the micro-pulling down method (µ-PD method) was used to continuously supply raw material while controlling the supply amount of the raw material according to the rate of change of the reference value 3A based on the maximum amplitude 1A and minimum amplitude 2A per cycle period for the frequency, as shown in FIG. 5 (Embodiment-based sample). As a result, it was possible to obtain a product with excellent functionality and physical properties. As a comparison example, a commercially available conventional manufacturing apparatus (without a frequency measurement device) was used (Comparison sample).

When produced using the apparatus described with reference to FIG. 2, the supply rate was stable. Moreover, alloy wire of the Embodiment-based sample thus obtained had good crystallinity. In contrast, alloy wire of Comparison sample did not have a constant concentration of solute metal elements, and only poor-quality alloy wire could be produced. In addition, the resulting alloy wire deteriorated quickly.

Moreover, as a result of comparing Embodiment-based sample with Comparison sample, variations were observed in the concentration of solute metal elements (composition of alloy elements) in Comparison sample, but no variations were observed in Embodiment-based sample, as shown in FIG. 6.

Each of the control means 104 and the stopping means of the processing apparatus according to the above-described embodiment can be a computer device equipped with a central processing unit (CPU) 301, a main memory device 302, an external memory device 303, a network connection device 304, etc., as shown in FIG. 7, and the above-described features (or processing method) can be realized by the CPU 301 caused to be operated by (or caused to execute) a program deployed in the main memory device 302. The above-described program is a program for causing a computer to execute the method shown in the above-described embodiment. The network connection device 304 connects to the network 305. The respective features can be executed in a distributed manner across multiple computer devices.

As described above, in accordance with the present invention, the supply of raw material is controlled according to the frequency of the high-frequency electromagnetic waves produced onto the liquid contained in the container, thereby making it possible to obtain uniformity in the liquid into which the raw material is being supplied.

For example, in accordance with conventional crystal growth, the heating frequency in high-frequency induction heating is controlled to be constant. During this type of crystal growth process, the frequency irradiated from the coil in high-frequency induction heating fluctuates, and intensive research by the inventors has revealed that this fluctuation causes changes in crystallinity. In particular, when raw materials are supplied to the melt intermittently, the oscillation frequency changes in a spike-like manner depending on the supply state, and the composition of the melt also changes, resulting in poor crystallinity of the resulting crystal and making it impossible to obtain the desired crystallinity.

Under such circumstances, the inventors have discovered that the raw material can be stably supplied to the liquid even when added by dripping, ejection, spraying or intermittent addition, and that this stable supply is beneficial for crystal growth. The inventors have further found that the processing apparatus and processing method described herein can solve all of the above-mentioned problems in the prior art at once.

Some or all of the above-described embodiments may also be described in, but are not limited to, Appendices described in the following.

### Appendix 1

A processing apparatus comprising:
a high-frequency irradiation means for irradiating a liquid contained in a container with high-frequency electromagnetic waves;
a supply means for supplying a raw material to the liquid;
a frequency measurement means for measuring a frequency of the high-frequency electromagnetic waves irradiated by the high-frequency irradiation means; and
a control means for controlling the supply of the raw material by the supply means according to a rate of change of a reference value, the reference value being based on a maximum amplitude value and a minimum amplitude value per cycle period for the frequency measured by the frequency measurement means.

### Appendix 2

The processing apparatus according to Appendix 1, wherein
the supply means supplies the raw material by any of dripping the raw material, ejecting the raw material, spraying the raw material, and intermittently supplying the raw material.

### Appendix 3

The processing apparatus according to Appendix 2, wherein
the control means controls any of an amount of raw material dripped, an amount of raw material ejected, and an amount of raw material sprayed.

### Appendix 4

The processing apparatus according to Appendix 2, wherein
the control step controls an interval between any of dripping operations, intervals between successive ejecting operations, and intervals between successive intermittent supply operations of the raw material.

### Appendix 5

The processing apparatus according to Appendix 1, wherein
the high-frequency irradiation means heats the liquid by high-frequency induction heating.

### Appendix 6

The processing apparatus according to any one of Appendices 1 to 4, further comprising
a stopping means for stopping an operation of the processing apparatus in response to a fluctuation range of a rate of change of the reference value.

### Appendix 7

A processing method comprising the steps of:
a high-frequency irradiation step of irradiating a liquid contained in a container with high-frequency electromagnetic waves;
a supply step of supplying a raw material to the liquid;
a frequency measurement step of measuring a frequency of the high-frequency electromagnetic waves irradiated in the high-frequency irradiation step; and
a control step of controlling the supply of the raw material in the supply step according to a rate of change of a reference value, the reference value being based on a maximum amplitude value and a minimum amplitude value per cycle period for the frequency measured in the frequency measurement step.

### Appendix 8

The processing method according to Appendix 7, wherein
the supplying step supplies the raw material by any of dripping the raw material, ejecting the raw material, spraying the raw material, and intermittent ejection of the raw material.

### Appendix 9

The processing method according to Appendix 8, wherein
the control step controls any of an amount of raw material dripped, an amount of raw material ejected, and an amount of raw material sprayed.

### Appendix 10

The processing method according to Appendix 8, wherein
the control step controls an interval between any of dripping operations, intervals between successive ejecting operations, and intervals between successive intermittent supply operations of the raw material.

### Appendix 11

The processing method according to Appendix 7, wherein
the high-frequency irradiation step involves heating the liquid by high-frequency induction heating.

### Appendix 12

The processing method according to any one of Appendices 7 to 11, further comprising
a stopping step of stopping an operation of an apparatus configured to carry out the processing method in response to a fluctuation range of a rate of change of the reference value.

It should be noted that the present invention is not limited to the embodiments described above, and it is clear that many modifications and combinations can be made by a person skilled in the art within the technical concept of the present invention.

### REFERENCE SYMBOLS LIST

101: high-frequency irradiation means; 102: supply means; 103: frequency measurement means; 104: control means; 121: container; 122: liquid

## Claims

1. A processing apparatus comprising:
a high-frequency irradiation means for irradiating a liquid contained in a container with high-frequency electromagnetic waves;
a supply means for supplying a raw material to the liquid;
a frequency measurement means for measuring a frequency of the high-frequency electromagnetic waves irradiated by the high-frequency irradiation means; and
a control means for controlling the supply of the raw material by the supply means according to a rate of change of a reference value, the reference value being based on a maximum amplitude value and a minimum amplitude value per cycle period for the frequency measured by the frequency measurement means.

2. The processing apparatus according to claim 1, wherein
the supply means supplies the raw material by any of dripping the raw material, ejecting the raw material, spraying the raw material, and intermittently supplying the raw material.

3. The processing apparatus according to claim 2, wherein
the control means controls any of an amount of raw material dripped, an amount of raw material ejected, and an amount of raw material sprayed.

4. The processing apparatus according to claim 2, wherein
the control means controls an interval between any of dripping operations, intervals between successive ejecting operations, and intervals between successive intermittent supply operations of the raw material.

5. The processing apparatus according to claim 1, wherein
the high-frequency irradiation means heats the liquid by high-frequency induction heating.

6. The processing apparatus according to any one of claims 1 to 4, further comprising
a stopping means for stopping an operation of the processing apparatus in response to a fluctuation range of a rate of change of the reference value.

7. A processing method comprising the steps of:
a high-frequency irradiation step of irradiating a liquid contained in a container with high-frequency electromagnetic waves;
a supply step of supplying a raw material to the liquid;
a frequency measurement step of measuring a frequency of the high-frequency electromagnetic waves irradiated in the high-frequency irradiation step; and
a control step of controlling the supply of the raw material in the supply step according to a rate of change of a reference value, the reference value being based on a maximum amplitude value and a minimum amplitude value per cycle period for the frequency measured in the frequency measurement step.

8. The processing method according to claim 7, wherein
the supplying step supplies the raw material by any of dripping the raw material, ejecting the raw material, spraying the raw material, and intermittent ejection of the raw material.

9. The processing method according to claim 8, wherein
the control step controls any of an amount of raw material dripped, an amount of raw material ejected, and an amount of raw material sprayed.

10. The processing method according to claim 8, wherein
the control step controls an interval between any of dripping operations, intervals between successive ejecting operations, and intervals between successive intermittent supply operations of the raw material.

11. The processing method according to claim 7, wherein
the high-frequency irradiation step involves heating the liquid by high-frequency induction heating.

12. The processing method according to any one of claims 7 to 11, further comprising
a stopping step of stopping an operation of the apparatus in response to a fluctuation range of a rate of change of the reference value.
